Europäisches Patentamt

European Patent Office

Office européen des brevets

(19)

(11) **EP 0 814 563 B1**

(12) **FASCICULE DE BREVET EUROPEEN**

(45) Date de publication et mention
de la délivrance du brevet:
**22.09.2004 Bulletin 2004/39**

(51) Int Cl.⁷: **H03K 3/53**, H03K 5/12

(21) Numéro de dépôt: **97401342.7**

(22) Date de dépôt: **13.06.1997**

(54) **Dispositif d'alimentation impulsionnelle à réseau de bobinages**

Impulsversorgungseinrichtung mit einem Netz von Spulen

Pulsed power supply with a network of coils

(84) Etats contractants désignés:
**CH DE GB IT LI**

(30) Priorité: **17.06.1996 FR 9607482**

(43) Date de publication de la demande:
**29.12.1997 Bulletin 1997/52**

(73) Titulaire: **COMMISSARIAT A L'ENERGIE
ATOMIQUE
75015 Paris Cédex 15 (FR)**

(72) Inventeurs:
• **Chatroux, Daniel
26200 Montelimar (FR)**
• **Rosoli, Jean-Marc
Les J du Soleil, 13013 Marseille (FR)**

(74) Mandataire: **Poulin, Gérard et al
BREVALEX
3, rue du docteur Lancereaux
75008 Paris (FR)**

(56) Documents cités:
**EP-A- 0 125 948          DE-A- 2 738 626
US-A- 4 707 619          US-A- 4 901 048
US-A- 5 313 481          US-A- 5 349 743
US-A- 5 487 214**

# Description

Domaine technique

La présente invention concerne un dispositif d'alimentation impulsionnelle d'une charge électrique.

Un tel dispositif peut être utilisé en particulier pour l'alimentation électrique d'un laser à vapeur de cuivre ou d'un laser à halogénures de cuivre tels que CuBr.

L'invention trouve plus généralement des applications dans toute alimentation électrique devant fournir des impulsions très brèves, c'est-à-dire d'une durée inférieure à 100 ns par exemple, et de fort courant, c'est-à-dire un courant pouvant atteindre quelques milliers d'ampères.

Etats de la technique antérieure

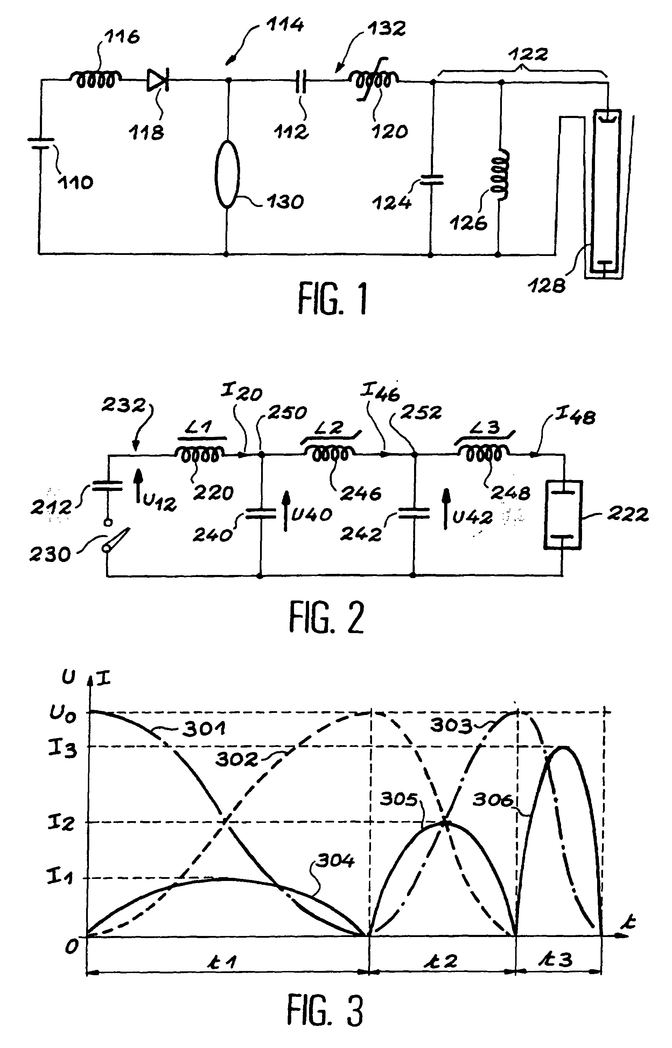

La figure 1 des dessins annexés indique un schéma de câblage d'une alimentation impulsionnelle de type connu.

L'alimentation comporte une source d'énergie 110, et un condensateur 112 dit condensateur d'accumulation, connectés mutuellement dans un circuit de charge repéré avec la référence 114. Le circuit de charge comporte, en série, outre la source d'énergie 110 et le condensateur 112, une bobine de charge 116, une diode de charge 118, une bobine à inductance saturable 120 et la charge électrique à alimenter 122. La charge électrique 122 est composée dans l'exemple de la figure 1 d'un condensateur dit condensateur 124 de crête (peaking) d'une bobine 126, dite bobine d'ionisation, et d'un tube laser 128.

Un circuit de décharge du condensateur d'accumulation 112 vers la charge électrique 122 comporte, en série avec ces éléments, la bobine à inductance saturable 120 et un thyratron 130. Le circuit de décharge porte la référence 132.

Dans une première phase de fonctionnement, le thyratron 130 est dans un état non-conducteur. Le condensateur d'accumulation 112 est chargé lentement sous un faible courant fourni par la source d'énergie 110 et traversant le circuit de charge 114. Le courant de charge traverse la diode 118 dans son sens passant.

Dans une deuxième phase de fonctionnement, très brève, le thyratron 130 qui est utilisé comme un interrupteur commandable est rendu conducteur pour déclencher une impulsion de courant. Les charges accumulées dans le condensateur 112 sont alors rapidement transférées vers la charge électrique 122, et plus précisément vers le condensateur de crête 124.

Le courant de décharge circulant alors dans le circuit de décharge 132 est de forte intensité.

Le thyratron 130 qui a la faculté de passer rapidement d'un état non-conducteur à un état conducteur est utilisé pour déclencher les impulsions de courant de décharge. Toutefois, l'expérience montre que pour des impulsions de courant très brèves et de forte amplitude, le thyratron a une durée de vie courte.

Pour soulager le thyratron, un interrupteur magnétique ayant la fonction d'une aide à la commutation peut lui être adjoint. On entend par interrupteur magnétique un composant électrique dont l'auto-inductance peut varier dans des proportions importantes entre un état saturé et non saturé.

Dans le schéma de la figure 1, l'interrupteur magnétique est formé par la bobine à inductance saturable 120. L'impédance que présente cette bobine peut varier d'un facteur 100 entre son état saturé et son état non saturé. Une telle bobine se comporte en effet comme un interrupteur.

Lorsque le thyristor 130 passe brusquement dans un état conducteur, la tension à ses bornes devient nulle et est en quelque sorte reportée aux bornes de la bobine 120. A partir de cet instant, la bobine 120 est d'abord dans un état non saturé et ne laisse passer quasiment aucun courant de décharge. Puis, la bobine passe dans un état de saturation dans lequel elle laisse passer un courant important du condensateur d'accumulation 112 vers la charge 122. La transition entre l'état non saturé et l'état saturé est très brève. Cette caractéristique, de même que la durée pendant laquelle la bobine reste dans l'état non saturé, sont ajustables par des paramètres physiques de fabrication de la bobine.

L'association au thyratron d'une telle aide à la commutation constitue certes une amélioration, mais reste insuffisante pour conférer au dispositif une fiabilité suffisante pour des applications industrielles.

En raison de cette piètre fiabilité, des composants de substitution sont proposés pour remplacer le thyratron.

Parmi ces composants on peut citer le thyristor qui accepte facilement des courants de forte intensité.

Le thyristor présente cependant l'inconvénient d'une conduction qui s'établit lentement. Après avoir été dans un état de non-conduction (bloqué) le thyristor ne devient pleinement conducteur qu'après un temps relativement long. La conduction commence autour de la gâchette puis s'étend lentement. Ainsi le thyristor n'est pas adapté à une utilisation dans un dispositif à impulsions courtes : pour des impulsions de l'ordre d'une microseconde, seule la partie de semiconducteur autour de la gâchette du thyristor assure la conduction. On peut noter par ailleurs que les thyristors ne sont pas commandables au blocage.

Une autre possibilité proposée pour réaliser l'interrupteur commandable de l'alimentation impulsionnelle est d'utiliser des transistors bipolaires à grille isolée de type IGBT. Ces transistors sont facilement commandables à la mise en conduction et au blocage. On peut se reporter à ce sujet au document (1) dont la référence est indiquée à la fin de la présente description.

Toutefois, comme les thyristors, les transistors IGBT n'autorisent pas des impulsions brèves, inférieures à la microseconde.

Ainsi, pour utiliser ces composants dans le dispositif d'alimentation impulsionnelle, celui-ci doit être équipé de plusieurs étages de compression. Une telle solution est décrite pour une alimentation de lasers à vapeur de cuivre pour des puissances de 200 W et 400 W dans les documents (2) et (3) dont la référence est également indiquée à la fin de la description.

La figure 2 des dessins annexés indique un schéma de principe d'un circuit à deux étages de compression dans une alimentation impulsionnelle d'un laser.

Dans la suite de la description des parties identiques ou similaires des différentes figures décrites sont repérées par des références identiques à l'exception du chiffre des centaines de ces références qui rappelle le numéro de la figure.

La figure 2 correspond au circuit de décharge 232 d'une alimentation impulsionnelle qui comme dans le cas de la figure 1 comporte un interrupteur commandable 230, tel qu'un transistor IGBT, par exemple, et un condensateur d'accumulation 212. Pour des raisons de simplification le circuit de charge du condensateur d'accumulation 212 n'est pas représenté sur la figure 2. Le circuit de décharge 232, est reliée une charge électrique 222, sous la forme d'un laser. Le circuit de décharge comporte par ailleurs deux condensateurs intermédiaires 240 et 242 et deux interrupteurs magnétiques 246, 248 formant, avec les condensateurs 240 et 242 des étages de compression des impulsions. Les interrupteurs magnétiques 246 et 248 se présentent sous la forme de bobines à inductance saturable. On peut noter par ailleurs que les condensateurs 212, 240 et 242 présentent des capacités sensiblement égales.

On note que le brevet US 4,607,619 décrit quant à lui un circuit utilisant un interrupteur à inductance saturable fonctionnant selon le même principe que celui ici décrit en relation avec la figure 2, pour un interrupteur à deux étages. Le schéma de cet interrupteur représenté en figure 1 de ce brevet comporte simplement un étage supplémentaire comportant une inductance saturable connectée en série avec les deux inductances saturables 246 et 248 représenté figure 2, et un condensateur supplémentaire connecté entre l'inductance supplémentaire et l'interrupteur 230 de la même façon que les condensateurs U40 et U42.

Sur la figure 2, de la présente demande, une première borne du condensateur d'accumulation 212 est reliée à un premier noeud 250 par l'intermédiaire d'une bobine 220. Le premier noeud 250 est relié à un second noeud 252 par l'intermédiaire du premier interrupteur magnétique 246 et le second noeud 252 est relié à la charge 222 par l'intermédiaire du deuxième interrupteur magnétique 248. Les noeuds 250 et 252 sont par ailleurs reliés à une deuxième borne du condensateur d'accumulation 212, respectivement par les condensateurs intermédiaires 240 et 242 et par l'interrupteur commandable 230.

La figure 3 des dessins annexés permet d'illustrer le fonctionnement du circuit de décharge. Il s'agit d'un graphique représentant en fonction du temps, et en échelle arbitraire, les tensions $U_{12}$, $U_{40}$ et $U_{42}$ aux bornes des condensateurs 212, 240 et 242 et les courants $I_{20}$, $I_{46}$ et $I_{48}$ traversant les bobines 220, 246 et 248 en direction de la charge électrique 222.

Sur la figure 3, l'origine des temps coïncide avec la fermeture de l'interrupteur 230. A partir de cet instant le condensateur 212 se décharge dans le condensateur 240 à travers la bobine 220. La tension $U_{12}$ chute d'une valeur $U_0$ à la valeur nulle selon la courbe 301, et pendant un temps $t_1$.

En même temps, comme le montre la courbe 302, la tension $U_{40}$ augmente pour atteindre la valeur $U_0$ au bout du temps $t_1$.

La bobine 246 est conçue de sorte que son inductance soit à saturation après le temps $t_1$. Le condensateur 240 se décharge alors dans le condensateur 242 pendant un temps $t_2$. Les tensions $U_{40}$ et $U_{42}$ aux bornes des condensateurs 240 et 242, indiquées par les courbes 302 et 303, évoluent sinusoïdalement.

La tension $U_{40}$ chute jusqu'à une valeur nulle et la tension $U_{42}$ augmente jusqu'à la valeur $U_0$ environ.

Enfin, la bobine 248 est conçue pour que son inductance soit à saturation après le temps $t_1+t_2$. Le condensateur 242 se décharge alors dans la charge électrique 222 pendant un temps $t_3$. Pendant le temps $t_3$ la tension $U_{42}$ aux bornes du condensateur 242 chute de la valeur $U_0$ à une valeur sensiblement nulle (courbe 303).

Les temps $t_1$, $t_2$ et $t_3$ sont respectivement égaux à $t_1 = \pi \sqrt{L_{20}.C/2}$, $t_2 = \pi \sqrt{L_{46}.C/2}$ et $t_3 = \pi \sqrt{L_{48}.C}$ où $L_{20}$, $L_{46}$, $L_{48}$ et C sont respectivement les valeurs à saturation des inductances 220, 246 et 248 et la capacité des condensateurs.

Les courbes 304, 305 et 306 indiquent les courants $I_{20}$, $I_{46}$ et $I_{48}$ traversant les bobines 220, 246 et 248 pendant les temps $t_1$, $t_2$ et $t_3$. Il apparaît d'une part que la valeur maximale atteinte par les courants de décharge, respectivement $I_1$, I2 et $I_3$ pendant les temps $t_1$, $t_2$ et $t_3$ croît de façon importante d'un étage du circuit de décharge à l'étage suivant. D'autre part les temps $t_1$, $t_2$ et $t_3$ sont tels que $t_3 < t_2 < t_1$. On forme ainsi des impulsions de courant de plus en plus brèves mais aussi de plus en plus intenses.

Les interrupteurs magnétiques utilisés pour les étages successifs du circuit de décharge doivent, par conséquent, présenter un fort calibre en courant. Les interrupteurs magnétiques doivent également présenter une valeur d'inductance la plus faible possible dans l'état saturé afin d'obtenir des impulsions très brèves.

D'autres contraintes telles que l'échauffement du matériau magnétique formant le noyau des bobines des interrupteurs sont également à prendre en compte.

En effet, les lasers à vapeur de cuivre et à halogénures (CuBr, CuHBr) nécessitent des alimentations pouvant fonctionner dans une gamme de fréquences de récurrence de 5 à 20 kHz. Or, les pertes dans les interrupteurs magnétiques augmentent avec la fréquence et l'échauffement des ferrites des bobines est important.

Pour faciliter le refroidissement du matériau magnétique on utilise habituellement des bobines à noyau torique dont le tore présente un grand diamètre, de l'ordre de 200 mm, par exemple, et une faible section.

Par ailleurs, les alimentations impulsionnelles évoquées ci-dessus mettent en jeu des tensions souvent importantes. Les tensions peuvent atteindre, dans certains cas, des valeurs de 25 kV à 100 kV. Ainsi, les fils conducteurs formant l'enroulement des bobines doivent être isolés par des gaines et/ou doivent être disposés de façon suffisamment éloignée les uns des autres. Les conducteurs doivent également être correctement isolés des ferrites constituant les noyaux, si celles-ci sont en un matériau peu résistif.

Les documents (4), (5) et (6) dont les références sont indiquées à la fin de la présente description donnent des exemples de réalisation d'interrupteurs magnétiques. Il s'agit par exemple de gros tores avec un bobinage par fils rigides ou d'autres éléments à inductance saturable de type coaxial ou à plaques.

Les interrupteurs magnétiques satisfaisant aux conditions évoquées ci-dessus sont souvent volumineux, et très coûteux. De plus, pour adapter leurs caractéristiques à celles d'un circuit de charge et à une charge électrique donnée la mise au point et le dimensionnement des interrupteurs est délicate.

La présente invention a pour but de proposer un interrupteur magnétique de faible coût et qui permette d'être aisément adapté aux caractéristiques et contraintes d'une alimentation impulsionnelle, telles qu'évoquées ci-dessus.

Un but de l'invention est aussi de proposer un interrupteur magnétique pour une alimentation impulsionnelle qui ait une excellente tenue en tension, avec des moyens d'isolation réduits.

Un autre but de l'invention est de proposer un interrupteur magnétique capable de commuter de forts courants dans des temps très brefs.

Un but de l'invention est encore de proposer un interrupteur magnétique utilisable dans des alimentations impulsionnelles à fréquence de récurrence élevée, et dont le refroidissement ne nécessite pas une installation coûteuse.

Exposé de l'invention

L'invention a plus précisément pour objet un dispositif d'alimentation impulsionnelle d'une charge électrique comprenant un circuit de charge d'au moins un condensateur dit condensateur d'accumulation et au moins un circuit de décharge du condensateur d'accumulation vers ladite charge électrique, le circuit de décharge comportant au moins un interrupteur magnétique. Pour atteindre les buts mentionnés ci-dessus, et conformément à l'invention, l'interrupteur magnétique comporte une pluralité de bobinages à inductance saturable répartis dans une pluralité de groupes de bobinages connectés en série et une pluralité de groupes de bobinages connectés en parallèle de telle sorte que chaque bobinage individuel appartienne à la fois à un unique groupe de bobinages connectés en série et un unique groupe de bobinages connectés en parallèle.

Selon un arrangement particulier des bobinages à inductance saturable, ceux-ci peuvent être disposés selon des lignes de bobinages dites étages et des colonnes de bobinages dites branches, chaque bobinage d'une ligne étant connecté en parallèle avec chaque autre bobinage de ladite ligne et chaque bobinage d'une colonne étant connecté en série avec chaque autre bobinage de ladite colonne.

Les lignes et les colonnes de bobinages correspondent dans ce cas respectivement aux groupes de bobinages connectés en parallèle et aux groupes de bobinages connectés en série.

Comme un certain nombre de bobinages sont connectés en sériedans le réseau, la tension supportée par chaque bobinage pris individuellement est réduite en raison de la répartition de la tension totale sur tous les bobinages en série.

Aussi lorsque les bobinages sont équipés d'un noyau en un matériau magnétique tel qu'une ferrite à base de manganèse ou de nickel, par exemple, ou un autre matériau magnétique suffisamment résistif, il est possible de bobiner directement les conducteurs du bobinage sur le noyau sans ajouter d'autres isolants.

Ainsi, comme les moyens d'isolation électrique sont réduits, il est possible d'utiliser des bobinages de petites dimensions facilement disponibles dans le commerce et peu onéreux. La multiplication du nombre de bobinages dans un réseau conforme à l'invention facilite également le refroidissement de ces composants. En particulier un refroidissement par air des composants devient envisageable alors qu'il est insuffisant pour les dispositifs de l'art antérieur.

De plus, les caractéristiques électriques et physiques du réseau de bobinages peuvent être ajustées avec une bonne précision en faisant varier respectivement le nombre de bobinages mis en série et le nombre de bobinages mis en parallèle dans le réseau. Ceci procure également un avantage important par rapport aux interrupteurs magnétiques de l'art antérieur. En effet, la modification des caractéristiques des interrupteurs magnétiques usuels requiert une adaptation de leur forme géométrique ou de leurs dimensions.

Selon un autre aspect particulier de l'invention, des bobinages peuvent comporter un enroulement conducteur électrique autour d'un noyau torique de matériau magnétique. L'enroulement peut être réalisé à partir d'un seul, mais préférentiellement d'une pluralité de fils électriques connectés en parallèle pour une meilleure répartition du courant autour du circuit magnétique formé par le noyau.

Le réseau de bobinages conforme à l'invention peut être utilisé dans un étage de compression magnétique des impulsions dans une alimentation impulsionnelle telle que décrite précédemment. Il peut aussi être utilisé comme une aide à la commutation d'un interrupteur commandable de l'alimentation.

A titre d'exemple, dans une réalisation particulière du dispositif d'alimentation, celui-ci peut comporter un circuit d'initiation de la décharge du condensateur d'accumulation vers la charge électrique. Ce circuit comporte un interrupteur commandable et un interrupteur magnétique d'aide à la commutation. Conformément à l'invention, cet interrupteur magnétique peut comporter une pluralité de bobinages à inductance saturable, connectée selon un réseau série/parallèle.

D'autres caractéristiques et avantages de l'invention ressortiront mieux de la description qui va suivre, en référence aux figures des dessins annexés, donnée à titre purement illustratif et non limitatif.

Brève description des figures

- la figure 1, déjà décrite, est un schéma de câblage d'une alimentation impulsionnelle d'un laser d'un type connu,
- la figure 2, déjà décrite, est un schéma de câblage d'un circuit de décharge d'une alimentation impulsionnelle d'un type connu, comportant plusieurs étages de compression magnétique des impulsions,
- la figure 3, déjà décrite, est un graphique indiquant les courants et tensions relevés en différents points du circuit de décharge de la figure 2,
- la figure 4 est une représentation schématique d'un réseau de bobinages conforme à l'invention,
- la figure 5 est une représentation schématique d'un exemple de bobinage individuel pouvant être utilisé dans le réseau de bobinages de la figure 4.
- la figure 6 est un schéma de câblage d'une alimentation impulsionnelle utilisant au moins un réseau de bobinages, conformément à l'invention, et
- les figures 7A, 7B et 7C sont des graphiques indiquant l'évolution au cours du temps des tensions en différents points de l'alimentation de la figure 6. Les tensions sont repérées en ordonnée et le temps en abscisse.

Description détaillée de modes de mise en oeuvre de l'invention.

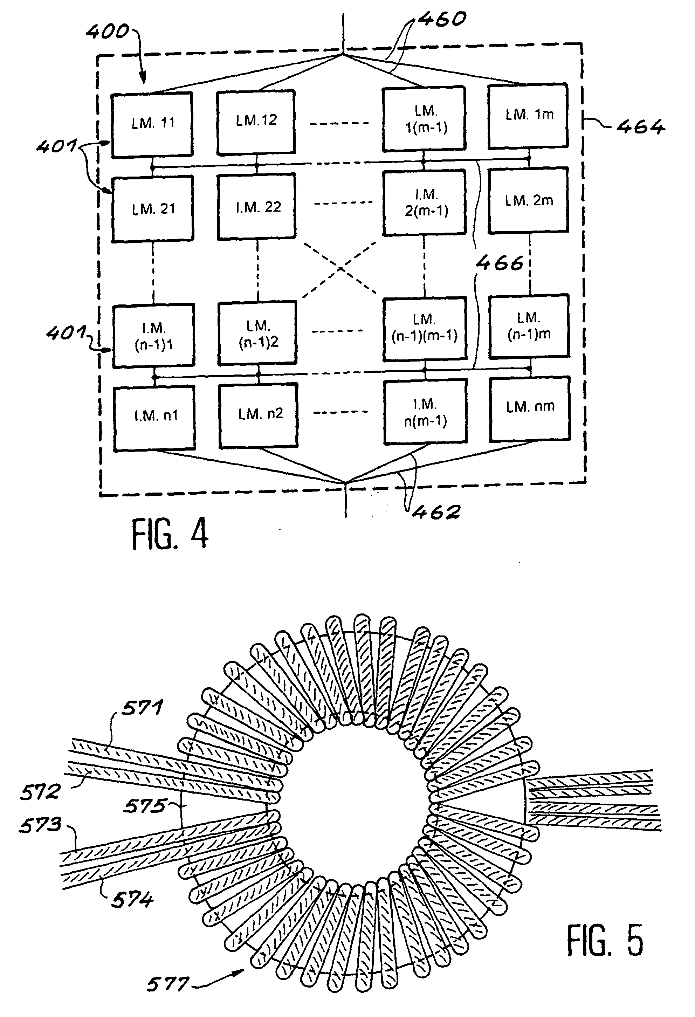

La figure 4 représente un réseau 400 de bobinages à induction saturable, conforme à l'invention. Il s'agit d'un réseau à n x m bobinages 401 où n et m sont des nombres entiers. Les bobinages sont, pour des raisons de simplification, représentés schématiquement par un rectangle. Dans l'exemple illustré, le réseau comporte n lignes et m colonnes, c'est-à-dire n groupes de bobinages en série et m groupes de bobinages en parallèle. Les groupes de bobinages en série sont désignés par étages du réseau et les groupes de bobinages en parallèle sont désignés par branches du réseau. Les bobinages sont collectivement indiqués par la référence 401 mais chaque bobinage individuel est repéré par une référence notée $I.M._{i,j}$ à deux variables i et j, i correspondant à un indice de ligne et j à un indice de colonne ; i varie de 1 à n et j de 1 à m. On considère par ailleurs que les caractéristiques des bobinages individuels sont sensiblement identiques.

Le nombre n de bobinages mis en série dans le réseau est ajusté en fonction de la tension susceptible d'être appliquée aux bornes du réseau.

En effet, on considère que tout bobinage à inductance saturable est caractérisé par un produit d'une tension par une durée qui correspond à la tension que le bobinage est capable de tenir entre ses bornes pendant cette durée avant de passer dans un état saturé.

Lorsqu'on utilise des bobinages individuels caractérisés par un produit tension-durée $V_1 \cdot t_1$, il est possible, en les associant dans un réseau de bobinages conforme à la figure 4, de tenir une tension $V_2$ pendant un temps $t_2$ entre les bornes du réseau, avec $V_2 \cdot t_2 = n \cdot V_1 \cdot t_1$ où n est le nombre de bobinages en série.

De plus, chaque branche de bobinages en série présente une inductance n fois supérieure à l'inductance d'un bobinage individuel.

Pour adapter l'inductance du réseau à une valeur souhaitée, inférieure à l'inductance d'une branche de bobinages en série du réseau, il suffit d'associer un nombre convenable m de branches de bobinage en parallèle dans le réseau.

Lorsque le réseau est utilisé dans un étage de compression magnétique, en association avec un condensateur, le taux de compression du réseau est le même que celui d'un bobinage individuel du réseau, séparé du réseau et soumis aux mêmes conditions que s'il était dans le réseau.

On définit le taux de compression $\tau$ tel que $\tau = \frac{\theta_1}{\theta_2}$, où $\theta_1$ est la durée pendant laquelle l'interrupteur magnétique reste bloqué alors qu'il est soumis à une tension donnée et $\theta_2$ la durée de l'impulsion du courant qui traverse l'interrupteur magnétique dans un état de saturation.

Lorsque les bobinages sont à noyau torique, les taux de compression $\tau_b$ d'un bobinage individuel et $\tau_r$ du réseau, sont tels que $\tau_b = \tau_r = \frac{2NS\Delta B}{\pi \ell I}$, où N est le nombre de spires du bobinage enroulées sur le tore, S la section du tore, $\Delta B$ la variation de l'induction magnétique entre les états saturés et non-saturé, $\ell$ l'inductance d'un bobinage individuel et I le courant qui le parcourt. Le produit tension temps $V \cdot \theta_1$ du réseau est tel que $V \cdot \theta_1 = 2NnS\Delta B$ lorsque n bobinages sont en série.

Un réseau de bobinages conforme à la figure 4 peut être réalisé sur une carte de circuit imprimé de type standard, indiquée en trait discontinu sur la figure avec la référence 464.

Les connexions d'arrivée du courant vers les bobinages et les connexions de départ, repérées respectivement avec les références 460 et 462 sur la figure 4 sont prévues de préférence sur toute la largeur de la carte de façon à assurer une répartition homogène du courant dans les différentes branches en parallèle du réseau.

Par ailleurs, les entrées, respectivement les sorties, des bobinages de chaque étage du réseau sont reliées mutuellement par des conducteurs 466. Cette mesure permet d'homogénéiser les tensions aux bornes des différents étages du réseau et d'éviter d'éventuels amorçages entre des bobinages en parallèle. Un autre avantage est aussi un meilleur équilibrage des courants dans le réseau lorsque le matériau magnétique des bobinages est saturé.

La figure 5 montre un exemple de réalisation d'un bobinage individuel destiné à être connecté dans un réseau de bobinages.

Le bobinage individuel comporte une pluralité, et de préférence quatre, fils conducteurs 571, 572, 573, 574, formant un enroulement 577 autour d'un noyau torique de matériau magnétique 575, tel qu'une ferrite. Les fils 571, 572, 573, 574 sont connectés en parallèle, c'est-à-dire que les fils qui vont d'un tore au tore suivant sont reliés en leurs extrémités. les fils 571 et 572 sont enroulés sur une partie du tore correspondant sensiblement à la moitié du tore selon un plan de section transversale et les fils 573 et 574 sont enroulés autour de l'autre moitié du tore.

Cette disposition ainsi que la multiplication du nombre de fils conducteurs permet une bonne répartition autour du matériau magnétique du courant traversant le bobinage. Cette caractéristique permet d'avoir une inductance magnétique à saturation particulièrement faible, ce qui est avantageux lorsque le réseau est utilisé comme interrupteur magnétique. Le nombre de fils conducteur est cependant limité de préférence à quatre pour simplifier la réalisation du bobinage.

La tension apparaissant aux bornes des bobinages individuels est préférentiellement limitée à une valeur maximale de 5 kV.

Chaque tore présente, par exemple, un diamètre extérieur de 36 mm, un diamètre intérieur de 22 mm et une hauteur de 15 mm.

Ces dimensions correspondent à des dimensions standards de tores disponibles dans le commerce qui sont donc peu coûteux.

De plus, en raison de leur petite taille, et de leur faible section, ces tores autorisent un refroidissement aisé du matériau magnétique.

Des réseaux de bobinages fabriqués avec de tels tores peuvent être refroidis par air.

Un réseau de bobinages tel que décrit ci-dessus peut être utilisé avantageusement comme un interrupteur magnétique d'aide à la commutation en association avec un interrupteur commandable tel qu'un transistor IGBT ou un thyratron, par exemple.

Le réseau de bobinages peut donc être connecté dans une alimentation impulsionnelle de type connu, telle que représentée à la figure 1, dans laquelle il prend la place et la fonction de l'interrupteur magnétique portant la référence 120.

Le fonctionnement d'une telle alimentation est expliqué de façon détaillée dans la partie introductive de la description à laquelle on peut se référer.

Le réseau de bobinages peut également être utilisé comme interrupteur magnétique dans un étage de compression des impulsions d'un circuit de décharge d'un dispositif d'alimentation impulsionnelle.

Dans ce cas, il peut être connecté selon le schéma de la figure 2 dans lequel il prend la place de l'un au moins des interrupteurs magnétiques 246 ou 248. Ces deux interrupteurs magnétiques de la figure 2 peuvent aussi être remplacés respectivement par deux réseaux de bobinages tels que décrits.

Le fonctionnement de l'alimentation de la figure 2 n'est pas rappelé ici et on pourra également se reporter à la partie introductive de la description.

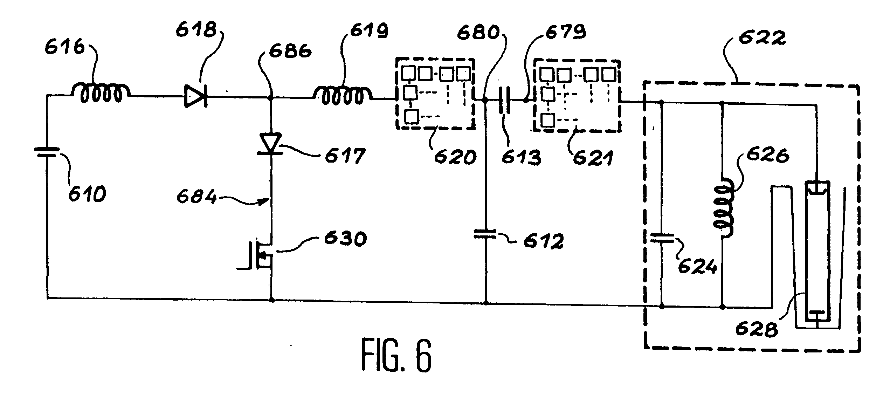

La figure 6 des dessins annexés montre le câblage d'une autre alimentation impulsionnelle dans laquelle l'utilisation conformément à l'invention du réseau de bobinages en tant qu'interrupteur magnétique est particulièrement adaptée. Le câblage de cette alimentation est voisine d'un schéma proposé dans le document (7) dont la référence est indiquée à la fin de la présente description.

L'alimentation de la figure 6 est reliée à une charge électrique 622 composée d'un condensateur de crête 624, d'un bobinage d'ionisation 626 et d'un tube laser 628. L'alimentation comporte, par ailleurs, un circuit de charge avec deux condensateurs d'accumulation 612 et 613. Ces condensateurs sont reliés à une première borne d'une source d'énergie 610 par l'intermédiaire d'un bobinage de charge 616, d'une diode 618, d'une bobine d'inversion 619 et d'un premier interrupteur magnétique de blocage 620, connectés en série dans le circuit de charge dans cet ordre. Le circuit de charge comprend également la charge électrique 622 connectée entre la deuxième borne de la source d'énergie et un deuxième interrupteur magnétique 621. L'interrupteur magnétique 621 relie la charge électrique à une borne 679 du condensateur d'accumulateur 613. Les interrupteurs magnétiques 620 et 621 sont chacun formés par un réseau de bobinages série/parallèle du type décrit ci-dessus.

Un noeud 680 entre l'interrupteur magnétique de blocage 620 et le condensateur 613 est relié également à la deuxième borne de la source d'énergie 610, par l'intermédiaire du condensateur d'accumulation 612.

Un circuit de décharge des condensateurs d'accumulation vers la charge électrique comprend dans l'ordre et en série : les condensateurs d'accumulation 612 et 613, le deuxième interrupteur magnétique 621 et la charge électrique 622 proprement dite.

Le dispositif d'alimentation comporte enfin un circuit d'initiation de la décharge des condensateurs d'accumulation. Ce circuit relié aux bornes du condensateur 612 comporte, à partir du noeud 680, le premier interrupteur magnétique 620, la bobine d'inversion 619 et une branche 684. Cette branche présente une première extrémité reliée à la bobine d'inversion 619 en un noeud 686 et une deuxième extrémité reliée directement au condensateur 612. La branche 684 comporte un interrupteur commandable 630 formé, par exemple, par un ou plusieurs transistors et une diode 617 branchée dans le sens passant de la première vers la deuxième extrémité de la branche 684.

Conformément à l'invention, l'un au moins, mais aussi les deux interrupteurs magnétiques 620 et 621 de l'alimentation peuvent être des réseaux de bobinages tels que décrits précédemment.

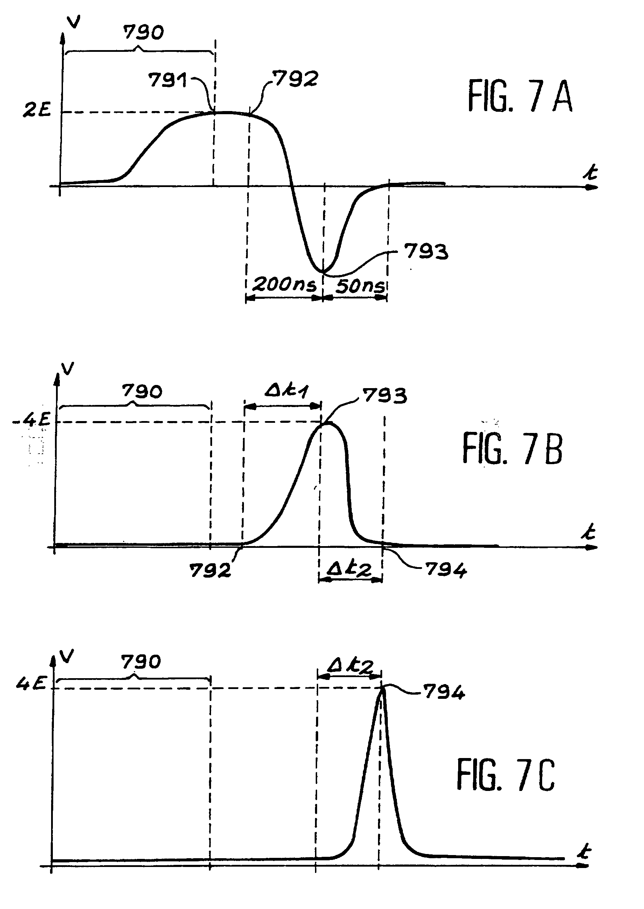

Les figures 7A, 7B et 7C indiquent respectivement, en fonction du temps, reporté en abscisses, les tensions au noeud 680, au noeud 679 et aux bornes de la charge électrique, reportées en ordonnée. Les tensions et le temps sont donnés en échelle arbitraire.

On explique sommairement ci-dessous le fonctionnement du dispositif de la figure 6 en corrélation avec les courbes des figures 7A à 7C.

Dans un premier temps, l'interrupteur 630 est ouvert, un courant de charge délivré par la source d'énergie 610 circule dans le circuit de charge. Les condensateurs 612 et 613 forment un circuit oscillant avec la bobine de charge 616 qui présente une valeur d'inductance élevée par rapport à tous les autres composants inductifs de l'alimentation. Ce circuit oscillant joue un rôle de doubleur de la tension de charge.

Les deux condensateurs 612 et 613 sont ainsi chargés sous un courant sensiblement identique et chacun à une tension sensiblement égale à 2E, en valeur absolue, où E est la tension aux bornes de la source d'énergie 610.

Cette première phase est repérée sur la courbe des figures 7A, 7B et 7C par la référence 790. Au terme de cette phase, la tension aux bornes des condensateurs 612 (figure 7A) est égale à 2E, la tension aux bornes du condensateur 613 est de -2E et la tension aux bornes de ces deux condensateurs réunis, de même que la tension aux bornes de l'interrupteur magnétique 821 est nulle(figure 9B). La tension aux bornes de la charge est également nulle (figure 9C). Le point repéré avec la référence 791 sur la figure 7A correspond à l'instant où la tension de charge de valeur absolue 2E est atteinte sur les condensateurs. La diode 618 empêche alors les condensateurs de se décharger vers la source d'énergie 610.

Le point 792 des figures 7A et 7B correspond à la fermeture de l'interrupteur commandable 630. Lorsque l'interrupteur commandable 630 se ferme la tension à ses bornes devient nulle et est reportée sur l'interrupteur magnétique 620, formé par un réseau de bobinages. Lorsque l'interrupteur magnétique atteint un état de saturation, repéré par la référence 792 sur les figures 7A et 7B, la tension aux bornes du condensateur 612 est inversée avec l'aide de la bobine d'inversion 619. La fin de la phase d'inversion est repérée par la référence 793.

Comme le montrent les figures 7B et 7A, la tension au noeud 679, c'est-à-dire aux bornes de l'interrupteur magnétique 621 est alors de -4E et la tension aux bornes du condensateur 612 est de -2E.

L'interrupteur magnétique 621, formé par un réseau de bobinages, est dimensionné de façon à se saturer à partir de l'instant où la tension aux bornes du condensateur d'accumulation 612 est inversée, c'est-à-dire à partir de l'instant repéré avec la référence 793.

Lorsque l'interrupteur magnétique 621 est saturé, le circuit de décharge est fermé et les condensateurs d'accumulation 612 et 613, en série dans ce circuit, se déchargent vers la charge électrique 622 et plus précisément dans le condensateur de crête 624. La tension aux bornes de la charge électrique 622, indiquée sur la figure 7C atteint sa valeur maximale, égale en valeur absolue à 4E, à un instant repéré par la référence 794. Cet instant correspond à l'amorçage du laser 628. Comme le montre la figure 7C, la tension est appliquée sous la forme d'une impulsion dont la durée est brève.

On désigne par $\Delta t_1$ la durée d'inversion de la tension aux bornes du condensateur 612, c'est-à-dire la durée s'écoulant entre les temps 792 et 793 et par $\Delta t_2$ la durée s'écoulant entre les temps 793 et 794.

Dans une réalisation pratique du dispositif décrit ci-dessus on souhaite alimenter un laser à gaz du type CuBr d'une puissance optique de 200 W.

Le rendement d'un tel laser étant de l'ordre de 2 à 3%, la puissance à délivrer est d'environ 8 kW.

L'alimentation envisagée pour le laser est prévue pour fournir des impulsions courtes de l'ordre de 100 ns avec une fréquence de récurrence des impulsions de 16 kHz. la tension fournie aux bornes du laser est de l'ordre de 50 kV à partir d'une source d'énergie qui est un générateur continu avec une tension E=12 kV. Avec un dispositif conforme à la figure 6, la tension aux bornes du laser est de 4E, c'est-à-dire 48 kV.

Pour bloquer la tension pendant une durée $\Delta t_1$ de 200 ns, on utilise un interrupteur magnétique 621 sous la forme d'un réseau de bobinages dont chaque branche comporte 12 tores bobinés en série.

Par ailleurs, pour obtenir une impulsion dont la durée est de 50 ns, 4 branches de 12 tores bobinés sont montés en parallèle dans le réseau. Le refroidissement des bobinages est effectué par circulation d'air ou d'huile.

Lorsqu'on souhaite alimenter une charge avec une puissance différente il suffit de modifier les dimensions du réseau, c'est-à-dire le nombre de branches qu'il comporte et le nombre de bobinages dans chaque branche.

Une telle adaptation ne nécessite aucune intervention sur les circuits magnétiques et électriques des bobinages, elle est donc peu coûteuse.

**TEXTES CITES DANS LA DESCRIPTION**

(1)
FR-A-2 654 878
(2)
Swart, P.H., von Bergman, H.M.
"Comparative evaluation of pulsing circuits for kHz excimer laser system"
Proc. 7th IEEE Pulsed Power Conference, pp. 293-296, IEEE, 1989
(3)
H.T.W. Tromp, P.H. Swart and H.M. von Bergman
"Bipolar pulsing circuits for high power high rep rate lasers"
Proc. 18th IEEE Power Modulator symposium, pp. 29-33, IEEE, 1990.
(4)
E.G. Cook, D.G. Ball, D.L. Birx, J.D. Branum, S.E. Peluso,
"High average power magnetic modulator for cooper lasers"
Proc. 8TH IEEE Pulsed Power Conference, pp. 537-542.
(5)
Don G. Ball, Livermore ; Dan Birx, Brentwood ; Edward G. Cook, Livermore, all of Calif.
"Magnetic compression laser driving circuit"
Brevet U.S. : 5,177,754 (Jan. 5, 1993)
(6)
W.C. Nunnally, J. Power, T.E. Springer
"Development of stripline magnetic modulators"
IEEE Conference record of 1982 15th power modulation symposium pp.28-31.
(7)
S. Gavay, P. Blau, M. Lando, I. Druckman, Z. Horvitz, Y. Yfrah, I. Hen, E. Miron, I. Smilanski
"Stabilization of high - power cooper vapour laser"
Optical and Quantum Electronics 23 (1991).

**Revendications**

1. Dispositif d'alimentation impulsionnelle d'une charge électrique (622) comprenant un circuit de charge d'au moins un condensateur (612, 613) dit condensateur d'accumulation et au moins un circuit de décharge du condensateur d'accumulation (612, 613) vers ladite charge électrique (622), le circuit de décharge comportant au moins un interrupteur magnétique (621), **caractérisé en ce que** l'interrupteur magnétique (621) comporte une pluralité de bobinages (401) à inductance saturable répartis dans une pluralité de groupes de bobinages connectés en série et une pluralité de groupes de bobinages connectés en parallèle de telle sorte que chaque bobinage individuel appartienne à la fois à un unique groupe de bobinages connectés en série et un unique groupe de bobinages connectés en parallèle.

2. Dispositif selon la revendication 1, **caractérisé en ce que** les bobinages ($I.M._{i,j}$) sont disposés selon des lignes de bobinages ($I.M._{1,j},...I.M._{n,j}$) et des colonnes de bobinages ($I.M._{i,1},..., I.M._{i,m}$), chaque bobinage d'une ligne étant connecté en parallèle avec chaque autre bobinage de ladite ligne et chaque bobinage d'une colonne étant connecté en série avec chaque autre bobinage de ladite colonne.

3. Dispositif selon la revendication 2, **caractérisé en ce que** les bobinages ($I.M._{i,j}$) présentent chacun une borne d'entrée et une borne de sortie, les bornes d'entrée, respectivement les bornes de sortie, des bobinages de chaque ligne de bobinages étant mutuellement reliées par un conducteur électrique (460, 462, 466).

4. Dispositif selon l'une des revendications 1 ou 2, **caractérisé en ce que** chaque bobinage comporte un enroulement conducteur électrique (577) autour d'un noyau torique (575).

5. Dispositif selon la revendication 4, **caractérisé en ce que** l'enroulement (577) comporte une pluralité de fils électriques (571, 572, 572, 574) connectés en parallèle.

6. Dispositif selon la revendication 5, **caractérisé en ce que** l'enroulement (577) comporte deux paires de fils (571, 572 ; 573, 574), chaque paire de fils étant respectivement enroulée autour d'une moitié du noyau torique.

7. Dispositif selon la revendication 4, **caractérisé en ce que** le noyau torique est en un matériau magnétique résistif à base de manganèse ou de nickel et **en ce que** l'enroulement conducteur électrique est bobiné directement sur le noyau.

8. Dispositif selon la revendication 1 comportant en outre un circuit d'initiation de la décharge comprenant en série un interrupteur commandable (630) et un interrupteur magnétique (620), **caractérisé en ce que** cet interrupteur magnétique (620) comporte également une pluralité de bobinages (401) à inductance saturable connectés selon un réseau (400) série/parallèle.

**Patentansprüche**

1. Vorrichtung zur Impulsversorgung einer elektrischen Last (622), die eine Schaltung zur Aufladung wenigstens eines Akkumulationskondensator genannten Kondensators (612, 613) und wenigstens eine Schaltung zur Entladung des Akkumulationskondensators (612, 613) in die elektrische Last (622) umfasst, wobei die Entladungsschaltung wenigstens einen magnetischen Schalter (621) umfasst,

**dadurch gekennzeichnet,**

**dass** der magnetische Schalter (621) eine Vielzahl von Sättigungsinduktivitäts-Spulen (401) umfasst, verteilt auf eine Vielzahl in Reihe geschalteter Spulengruppen und eine Vielzahl parallelgeschalteter Spulengruppen, so dass jede einzelne Spule zugleich zu einer einzigen in Reihen geschalteten Spulengruppe und zu einer einzigen parallelgeschalteten Spulengruppe gehört.

**2.** Vorrichtung nach Anspruch 1, **dadurch gekennzeichnet, dass** die Spulen (I.M.$_{i,j}$) gemäß Spulen-Zeilen (I.M.$_{1,j}$,..., I.M.$_{n,j}$) und Spulen-Spalten (I.M.$_{i,1}$,..., I.M.$_{i,m}$) angeordnet sind, wobei jede Spule einer Zeile parallelgeschaltet ist mit jeder anderen Spule der genannten Zeile, und jede Spule einer Spalte in Reihe geschaltet ist mit jeder anderen Spule der genannten Spalte.

**3.** Vorrichtung nach Anspruch 2, **dadurch gekennzeichnet, dass** jede der Spulen (I.M.$_{i,j}$) einen Eingangsanschluss und einen Ausgangsanschluss aufweist, wobei die Eingangsanschlüsse beziehungsweise die Ausgangsanschlüsse der Spulen jeder Spulen-Zeile gegenseitig durch einen elektrischen Leiter (460, 462, 466) verbunden sind.

**4.** Vorrichtung nach einem der Ansprüche 1 oder 2, **dadurch gekennzeichnet, dass** jede Spule eine elektrisch leitfähige Wicklung (577) um einen Ringkem (575) herum umfasst.

**5.** Vorrichtung nach Anspruch 4, **dadurch gekennzeichnet, dass** die Spule (577) eine Vielzahl parallelgeschalteter elektrischer Drähte (571, 572, 573, 574) umfasst.

**6.** Vorrichtung nach Anspruch 5, **dadurch gekennzeichnet, dass** die Spule (577) zwei Drahtpaare (571, 572; 573, 574) umfasst, wobei jedes Paar jeweils auf eine Hälfte des Ringkerns gewickelt ist.

**7.** Vorrichtung nach Anspruch 4, **dadurch gekennzeichnet, dass** der Ringkern aus einem resitiven magnetischen Material auf Mangan- oder Nickelbasis ist, und dadurch, dass die elektrisch leitfähige Wicklung direkt auf den Kern gewickelt ist.

**8.** Vorrichtung nach Anspruch 1, die außerdem eine Schaltung zur Initialisierung der Entladung umfasst, welche, in Reihe geschaltet, einen steuerbaren Schalter (630) und einen magnetischen Schalter (620) umfasst, **dadurch gekennzeichnet, dass** dieser magnetische Schalter (620) ebenfalls eine Vielzahl von Sättigungsinduktivitäts-Spulen (401) umfasst, verbunden durch ein Reihen-/Parallelschaltungs-Netzwerk (400).

**Claims**

**1.** Pulsed power supply for an electrical load (622) comprising a circuit for charging at least one capacitor (612, 613), referred to as an accumulation capacitor, and at least one circuit for discharging the accumulation capacitor (612, 613) into the said electrical load (622), the discharge circuit comprising at least one magnetic switch (621), **characterized in that** the magnetic switch (621) comprises a plurality of saturable inductance coils (401) divided into a plurality of groups of coils connected in series and a plurality of groups of coils connected in parallel such that each individual coil belongs, at the same time, to one of the groups of coils connected in series and one of the groups of coils connected in parallel.

**2.** Device according to Claim 1, **characterized in that** the coils (I.M.$_{i,j}$) are arranged according to rows of coils (I.M.$_{1,j}$,...,I.M.$_{n,j}$) and columns of coils (I.M.$_{i,1}$,...,I.M.$_{i,m}$), each coil within a row being connected in parallel with each other coil within the said row and each coil within a column being connected in series with each other coil within the said column.

**3.** Device according to Claim 2, **characterized in that** the coils (I.M.$_{i,j}$) each have an input terminal and an output terminal, the input terminals and, respectively, the output terminals of the coils of each row of coils being mutually linked by an electrical conductor (460, 462, 466).

**4.** Device according to either of Claims 1 and 2, **characterized in that** each coil comprises an electrically conducting winding (577) around a toroidal core (575).

**5.** Device according to Claim 4, **characterized in that** the winding (577) comprises a plurality of electrical wires (571, 572, 573, 574) connected in parallel.

**6.** Device according to Claim 5, **characterized in that** the winding (577) comprises two pairs of wires (571, 572; 573, 574), each pair of wires being respectively wound around one half of the toroidal core.

**7.** Device according to Claim 4, **characterized in that** the toroidal core is made from a resistive manganese- or nickel-based magnetic material and **in that** the electrically conducting winding is wound directly onto the core.

8. Device according to Claim 1, additionally comprising a discharge initiation circuit comprising in series a controllable switch (630) and a magnetic switch (620), **characterized in that** this magnetic switch (620) also comprises a plurality of saturable inductance coils (401) connected according to a series/parallel network (400).

FIG. 1

FIG. 2

FIG. 3

FIG. 4

FIG. 5

FIG. 6

EP 0 814 563 B1

EP 0 814 563 B1

FIG. 7 A

FIG. 7 B

FIG. 7 C

14